**Europäisches Patentamt**

**European Patent Office**

**Office européen des brevets**

(19)

(11) Veröffentlichungsnummer: **0 218 913**
**B1**

(12) **EUROPÄISCHE PATENTSCHRIFT**

(45) Veröffentlichungstag der Patentschrift:
**11.04.90**

(51) Int. Cl.⁴: **H03K 5/26**

(21) Anmeldenummer: **86112480.8**

(22) Anmeldetag: **09.09.86**

(54) **Digitaler Differenzfrequenzmischer.**

(30) Priorität: **12.09.85 DE 3532619**

(43) Veröffentlichungstag der Anmeldung:
**22.04.87 Patentblatt 87/17**

(45) Bekanntmachung des Hinweises auf die Patenterteilung:
**11.04.90 Patentblatt 90/15**

(84) Benannte Vertragsstaaten:
**AT BE CH DE FR GB IT LI NL SE**

(56) Entgegenhaltungen:
**DE-A- 2 750 476**
**US-A- 3 526 841**
**US-A- 3 866 129**

(73) Patentinhaber: **Siemens Aktiengesellschaft,**
**Wittelsbacherplatz 2, D-8000 München 2(DE)**

(72) Erfinder: **Müller, Martin, Dipl.-Ing.,**
**Knappertsbuschstrasse 18, D-8000 München 81(DE)**

ACTORUM AG

## Beschreibung

Die Erfindung betrifft einen digitalen Differenzfrequenzmischer, sowie ein Verfahren zur Gewinnung eines digitalen Differenzfrequenzsignals gemäß dem Oberbegriff des Patentanspruchs 1.

Differenzfrequenzmischer erzeugen aus zwei binären Eingangssignalen mit vorgegebenen Frequenzen ein binäres Ausgangssignal mit der Differenzfrequenz. Solche digitale Differenzfrequenzmischer werden beispielsweise bei einem Datenmultiplexer für ein Richtfunkgerät eingesetzt, bei dem die Phasenbeziehung zwischen zwei Datentakten ausgewertet werden soll.

Ein Frequenzmischer, der in erster Linie ein Ausgangssignal mit der Differenzfrequenz abgibt, ist aus der DE-A 3 130 177 bekannt. Bei diesem Frequenzmischer, der durch ein D-Flip-Flop realisiert ist, dürfen die Frequenzen der Eingangssignale nur wenig unterschiedlich sein.

Der Erfindung liegt die Aufgabe zugrunde, ein Verfahren zur Gewinnung eines digitalen Differenzfrequenzsignals anzugeben, bei dem die Frequenzen der Eingangssignale keinen besonderen Einschränkungen unterliegen.

Diese Aufgabe wird erfindungsgemäß dadurch gelöst, daß durch eine erste EXOR-Verknüpfung zwischen dem ersten und dem zweiten Signal ein erstes Verknüpfungssignal erhalten wird, daß durch eine zweite EXOR-Verknüpfung zwischen dem ersten, um ein Viertel der ersten Periodendauer verzögerten Signal und dem zweiten, um ein Viertel der zweiten Periodendauer verzögerten Signal ein zweites Verknüpfungssignal erhalten wird, daß durch eine erste UND-Verknüpfung zwischen dem ersten und dem zweiten Verknüpfungssignal ein drittes Verknüpfungssignal erhalten wird, daß durch eine zweite UND-Verknüpfung zwischen dem ersten Verknüpfungssignal in invertierter Form und dem zweiten Verknüpfungssignal in invertierter Form ein viertes Verknüpfungssignal erhalten wird und daß das dritte Verknüpfungssignal dem Setzimpulseingang und das vierte Verknüpfungssignal dem Rücksetzeingang der als RS-Flip-Flop ausgebildeten Kippstufe zugeführt werden.

Im folgenden wird die Erfindung anhand eines in der Zeichnung dargestellten Ausführungsbeispieles näher erläutert.

Dabei zeigen

Fig. 1 den erfindungsgemäßen digitalen Differenzfrequenzmischer, und

Fig. 2 Impulsfolgen auf einigen Leitungen des Differenzfrequenzmischers.

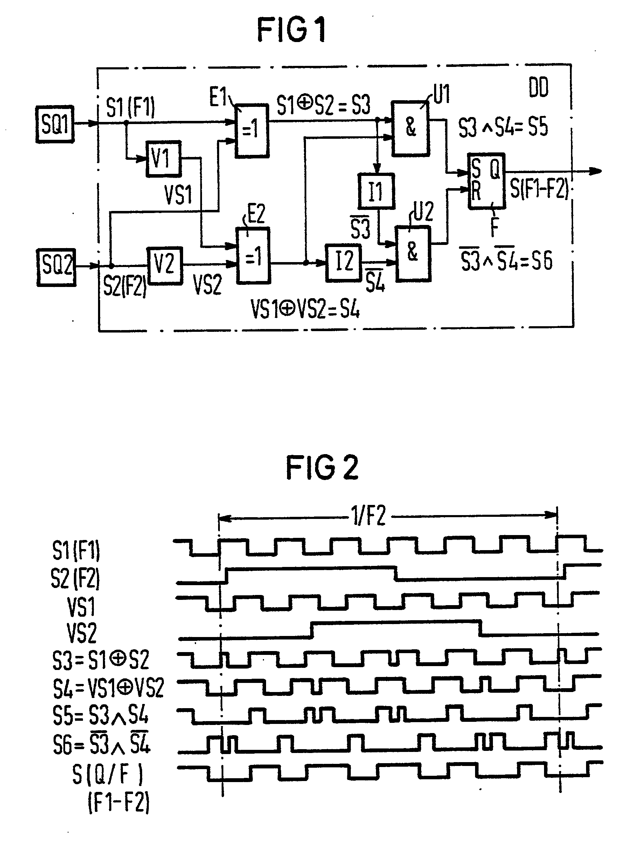

In Fig. 1 ist der erfindungsgemäße digitale Differenzfrequenzmischer DD dargestellt, an den von einer ersten Signalquelle SQ1 ein erstes Signal S1 mit der Frequenz F1, und an den von einer zweiten Signalquelle SQ2 ein zweites Signal S2 mit der Frequenz F2 gegeben werden. Bei den Signalen S1 und S2 handelt es sich um binäre, rechteckförmige Impulsfolgen.

Im folgenden wird auch auf die in Fig. 2 dargestellten Impulsfolgen verwiesen. In Fig. 2 ist durch unterbrochene, senkrechte Linien eine Periode des zweiten Signals S2 mit dem Wert 1/F2 markiert. Zur einfacheren Erläuterung des erfindungsgemäßen Differenzfrequenzmischers ist die Frequenz F1 des ersten Signals S1 als ein Vielfaches der Frequenz F2 des zweiten Signals S2 gewählt. Diese Bedingung ist aber keine Voraussetzung.

Das erste Signal S1 liegt an dem einen Eingang eines ersten EXOR-Gatters E1, und über eine erste Verzögerungsstufe V1 als ertes verzögertes Signal VS1 an dem einen Eingang eines zweiten EXOR-Gatters E2 an. Das zweite Signal S2 liegt an dem anderen Eingang des ersten EXOR-Gatters E1, und über eine zweite Verzögerungsstufe V2 als zweites verzögertes Signal VS2 an dem anderen Eingang des zweiten EXOR-Gatters E2 an. Die Verzögerungzeit der ersten Verzögerungsstufe V1 beträgt eine viertel Periode des ersten Signals S1, und die Verzögerungzeit der zweiten Verzögerungsstufe V2 beträgt eine viertel Periode des zweiten Signals S2.

Ein vom Ausgang des ersten EXOR-Gatters E1 abgegebenes drittes Signal $\overline{S3}$, daß der modulo-2-Summe aus dem ersten und dem zweiten Signal S1, S2 entspricht, liegt an dem einen Eingang eines ersten AND-Gatters U1, und über einen ersten Inverter I1 als invertiertes drittes Signal $\overline{S3}$ an dem einen Eingang eines zweiten AND-Gatters U2 an. Ein vom Ausgang des zweiten EXOR-Gatters E2 abgegebenes viertes Signal S4, das der modulo-2-Summe aus dem verzögerten ersten und dem verzögerten zweiten Signal VS1, VS2 entspricht, liegt an dem anderen Eingang des ersten AND-Gatters U1, und über einen zweiten Inverter I2 als invertiertes viertes Signal $\overline{S4}$ am anderen Eingang des zweiten AND-Gatters U2 an.

Das dritte und das vierte Signal S3, S4 haben in einem beliebigen Intervall, dessen Dauer gleich ist der Periode des zweiten Signals S2 mit dem Wert 1/F2, eine positive und eine negative Flanke mehr als das erste Signal S1. Das dritte und das vierte Signal S3, S4 weisen daher eine Frequenz auf, die der Summenfrequenz aus der Frequenz des ersten Signals S1 und der Frequenz des zweiten Signals S2 entspricht.

Ein vom Ausgang des ersten AND-Gatters U1 abgegebenes fünftes Signal S5, das der logischen UND-Verknüpfung aus dem dritten und dem vierten Signal S3, S4 entspricht, liegt an einem Setzimpulseingang S eines RS-Flipflops F an. Ein vom Ausgang des zweiten AND-Gatters U2 abgegebenes sechstes Signal, das der logischen Verknüpfung aus dem invertierten dritten und dem invertierten vierten Signal $\overline{S3}$, S4 entspricht, liegt an einem Rücksetzimpulseingang R des RS-Flipflops F an. Von einem Ausgang Q des RS-Flipflops F wird ein Ausgangssignal S abgegeben, dessen Frequenz gleich ist dem Differenzwert der Frequenzen des ersten Signales S1 und des zweiten Signales S2.

Beim fünften und sechsten Signal S5, S6 fallen die Impulse des einen Signals zeitlich in die Lücke zwischen die Impulse des anderen Signals, mit Ausnahme der Lücke zwischen den Doppelimpulsen, die zweimal während eines Intervalls mit der Dauer 1/F2 auftreten. Da das fünfte Signal S5 am Setzimpuls S und das sechste Signal S6 am Rücksetzimpulseingang R des RS-Flipflops F anliegen, wirken die Doppelimpulse jedes Signals jeweils nur einmal als Setz- bzw. Rücksetzimpuls. Aus diesem Grund enthält das Ausgangssignal S in einem beliebigen Intervall der Dauer 1/F2 eine positive und eine negative Flanke weniger als das erste Signal S1. Die Frequenz des Ausgangssignals ist daher die gewünschte Differenzfrequenz F1-F2 aus der Frequenz F1 des ersten Signals S1 und der Frequenz F2 des zweiten Signals S2.

Bezugszeichenliste

SQ 1, 2    erste, zweite Signalquelle
S1-6    erstes-sechstes Signal
VS1, 2    verzögertes erstes, zweites Signal
F1, 2    Frequenzen
E1/2    erstes, zweites EXOR-Gatter
V1/2    erste, zweite Verzögerungsstufe
I1/2    erster, zweiter Inverter
U1/2    erstes, zweites AND-Gatter
F    RS-Flipflop
S    Ausgangssignal

## Patentansprüche

1. Verfahren zur Gewinnung eines digitalen Differenzfrequenzsignals mit einer Frequenz, die gleich ist dem Differenzwert der Frequenz (F1) eines ersten Signals (S1) mit einer ersten Periodendauer und der Frequenz (F2) eines zweiten Signals (S2) mit einer zweiten Periodendauer unter Verwendung einer bistabilen Kippstufe, an deren Ausgang das Differenzfrequenzsignal abgenommen werden kann,
dadurch gekennzeichnet,
— daß durch eine erste EXOR-Verknüpfung zwischen dem ersten und dem zweiten Signal (S1, S2) ein erstes Verknüpfungssignal (S3) erhalten wird;
— daß durch eine zweite EXOR-Verknüpfung zwischen dem ersten, um ein Viertel der ersten Periodendauer verzögerten Signal (VS1) und dem zweiten, um ein Viertel der zweiten Periodendauer verzögerten Signal (VS2) ein zweites Verknüpfungssignal (S4) erhalten wird;
— daß durch eine erste UND-Verknüpfung zwischen dem ersten und dem zweiten Verknüpfungssignal (VS1, VS2) ein drittes Verknüpfungssignal (S5) erhalten wird;
— daß durch eine zweite UND-Verknüpfung zwischen dem ersten Verknüpfungssignal (S3) in invertierter Form und dem zweiten Verknüpfungssignal (S4) in invertierter Form ein viertes Verknüpfungssignal (S6) erhalten wird und
— daß das dritte Verknüpfungssignal (S5) dem Setzimpulseingang (S) und das vierte Verknüpfungssignal (S6) dem Rücksetzeingang (R) der als RS-Flipflop ausgebildeten Kippstufe (F) zugeführt werden.
2. Digitaler Differenzfrequenzmischer mit einer bistabilen Kippstufe, an der ein Ausgangssignal (S) mit einer Frequenz (F1–F2), die gleich ist dem Differenzwert der Frequenz (F1) eines ersten Signals (S1) und der Frequenz (F2) eines zweiten Signals (S2) abgreifbar ist, gekennzeichnet durch
ein erstes EXOR-Gatter (E1), an dem das erste Signal (S1) und das zweite Signal (S2) anliegen,
durch ein zweites EXOR-Gatter (E2), an der ein erstes verzögertes Signal (VS1) und ein zweites verzögertes Signal (VS2) anliegen, wobei die Verzögerungszeiten jeweils ein Viertel der jeweiligen Periodendauer betragen, durch ein erstes AND-Gatter (U1), an dem die Ausgangssignale des ersten EXOR-Gatters (E1) und des zweiten EXOR-Gatters (E2) anliegen,
durch ein zweites AND-Gatter (U2), an dem die jeweils invertierten Ausgangssignale des ersten EXOR-Gatters (E1) und des zweiten EXOR-Gatters (E2) anliegen,
und durch eine als RS-Flipflop (F) ausgebildete bistabile Kippstufe, an deren Setzimpulseingang (S) das Ausgangssignal des ersten AND-Gatters (U1) und an deren Rücksetzimpulseingang (R) das Ausgangssignal (S) des zweiten AND-Gatters (U2) anliegen.

## Claims

1. Method for obtaining a digital difference-frequency signal with a frequency which is the same as the difference between the frequency (F1) of a first signal (S1) having a first period and the frequency (F2) of a second signal (S2) having a second period using a bistable trigger stage at the output of which the difference-frequency signal can be tapped, characterized
— in that a first logic signal (S3) is obtained by means of a first logic exclusive OR (EXOR) operation on the first and the second signal (S1, S2);
— in that a second logic signal (S4) is obtained by means of a second logic exclusive OR (EXOR) operation on the first signal (VS1) delayed by a quarter of the first period and on the second signal (VS2) delayed by a quarter of the second period;
— in that a third logic signal (S5) is obtained by means of a first logic AND operation on the first and the second logic signals (VS1, VS2);
— in that a fourth logic signal (S6) is obtained by means of a second logic AND operation on the first logic signal (S3) in inverted form and on the second logic signal (S4) in inverted form and
— in that the third logic signal (S5) is fed to the set-pulse input (S) and the fourth logic signal (S6) is fed to the reset-pulse input (R) of the trigger stage (F) constructed as an RS-flip-flop.
2. Digital difference-frequency mixer having a bistable trigger stage, at which an output signal (S) with a frequency (F1–F2) which is the same as the difference between the frequency (F1) of a first signal (S1) and the frequency (F2) of a second signal (S2) can be tapped off, characterized by a first EXOR-gate (E1), at which the first signal (S1) and the second signal (S2) are present, by a second EXOR-gate (E2), at which a first delayed signal (VS1) and a second delayed signal (VS2) are present, the delay time in each case being one quarter of the respective period, by a first AND-gate (U1), at which the output signals of the first EXOR-gate (E1) and of the second EXOR-gate (E2) are present, by a second AND-gate (U2), at which the, in each case inverted, output signals of the first EXOR-gate (E1) and of the second EXOR-gate (E2) are present, and by a bistable trigger stage constructed as an RS-flip-flop (F), at the set-pulse input (S) of which the output signal of the first AND-gate (U1) is present and at the reset-pulse input (R) of which the output signal (S) of the second AND-gate (U2) is present.

## Revendications

1. Procédé pour former un signal numérique à fréquence différentielle, dont la fréquence est égale à la différence entre la fréquence (F1) d'un premier signal (S1) possédant une première période et la fréquence (F2) d'un second signal (S2) possédant une seconde période, moyennant l'utilisation d'un étage à bascule bistable à la sortie duquel le signal à fréquence différentielle peut être prélevé, caractérisé par le fait

   – qu'un premier signal combinatoire (S3) est formé par une première combinaison OU-EXCLUSIF des premier et second signaux (S1, S2);
   – qu'un second signal combinatoire (S4) est formé par une seconde combinaison OU-EXCLUSIF du premier signal (VS1) retardé d'un quart de la première période, et du second signal (VS2) retardé d'un quart de la seconde période;
   – qu'un troisième signal combinatoire (S5) est formé par une première combinaison ET entre les premier et second signaux combinatoires (VS1, VS2);
   – qu'un quatrième signal combinatoire (S6) est formé par une seconde combinaison ET du premier signal combinatoire (S3) sous forme inversée et du second signal combinatoire (S4) sous forme inversée; et
   – que le troisième signal combinatoire (S5) est envoyé à l'entrée (S) des impulsions de positionnement et que le quatrième signal combinatoire (S6) est envoyé à l'entrée (R) de remise à l'état initial de l'étage à bascule bistable (F) agencée sous la forme d'une bascule bistable de type RS.

2. Mélangeur numérique délivrant une fréquence différentielle comportant un étage à bascule bistable, sur lequel peut être prélevé un signal de sortie (S) possédant une fréquence (F1–F2), égale à la différence entre la fréquence (F1) d'un premier signal (S1) et la fréquence (F2) d'un second signal (F2), caractérisé par une première porte OU-EXCLUSIF (E1), à laquelle sont envoyés le premier signal (S1) et le second signal (S2), par une seconde porte OU-EXCLUSIF (E2), à laquelle sont envoyés un premier signal retardé (VS1) et un second signal retardé (VS2), les temps de retard étant égaux respectivement au quart de la période respective, par une première porte ET (U1), à laquelle sont envoyés les signaux de sortie de la première porte OU-EXCLUSIF (E1) et de la seconde porte OU-EXCLUSIF (E2),

par une seconde porte ET (U2), à laquelle sont envoyés les signaux de sortie respectivement inversés de la première porte OU-EXCLUSIF (E1) et de la seconde porte OU-EXCLUSIF, et par un étage à bascule bistable agencé à la manière d'une bascule bistable (F) de type RS, à l'entrée (S) des impulsions de positionnement de laquelle est envoyé le signal de sortie de la première porte ET (U1) et à l'entrée (R) des impulsions de remise à l'état initial de laquelle est envoyé le signal de sortie (S) de la seconde porte ET (U2).

# FIG 1

# FIG 2